# EUROPEAN PATENT APPLICATION

(11) **EP 3 474 392 A1**
(43) Date of publication of application: **24.04.2019**
(21) Application number: 17197207.8
(22) Date of filing: 19.10.2017
(51) Int. Cl.: H01S 5/00, H01S 5/068, F21V 23/04, F21V 25/04

(54) **EYE SAFE LASER DEVICE**

(71) Applicant: Koninklijke Philips N.V., 5656 AE Eindhoven (NL)
(72) Inventor: LAWRENSON, Matthew John, 5656 AE Eindhoven (NL); NOLAN, Julian Charles, 5600 AE Eindhoven (NL); GRONENBORN, Stephan, 5600 AE Eindhoven (NL); WALKER, Nicholas, 5600 AE Eindhoven (NL); VAN DEN BERG, Jan Jasper, 5600 AE Eindhoven (NL)
(74) Representative: de Haan, Poul Erik

(57) **Abstract**

The invention describes a laser device comprising at least one laser (10) arranged to emit laser light (12), a light spreading structure (20) arranged to spread the laser light (10) such that an energy density of the spread laser light (22) is reduced in comparison to an energy density of the laser light (12), the laser device further comprising a sensor structure (30) mechanically coupled with a light outcoupling surface of the light spreading structure (20), wherein the sensor structure (30) is arranged to change a physical property in reaction to a change of the reduction of the energy density of the spread laser light (22) in comparison to the energy density of the laser light (12), and wherein the sensor structure (30) is arranged to be coupled to an electrical driver (40) for electrically driving the laser (10) such that the change of the physical property of the sensor structure (30) can be detected by the electrical driver (40) during operation of the laser device.

Invention further describes a method of the detecting a malfunction of the laser device.

## Description

### FIELD OF THE INVENTION:

The invention relates to a laser device enabling improved eye safety and a corresponding method of detecting a malfunction of the laser device.

### BACKGROUND OF THE INVENTION:

Lasers can cause damage to human eyes, with thermal effects being the predominant cause of injury. Laser light with wavelengths in the visible to NIR range can enter the eyeball and cause heating (and thus potentially damage) of the cornea and lens. Various safety standards are in operation to ensure the safe use of lasers.

### SUMMARY OF THE INVENTION:

It is an object of the present invention to provide a laser device with improved eye safety.

The object is achieved with the laser device according to claim 1. Advantageous embodiments of the laser device are subject matter of the dependent claims or are described in the subsequent portions of the description and preferred embodiments.

According to a first aspect a laser device comprising at least one laser arranged to emit laser light, a light spreading structure arranged to spread the laser light such that an energy density of the spread laser light is reduced in comparison to an energy density of the laser light. The laser device further comprises a sensor structure mechanically coupled with a light outcoupling surface of the light spreading structure. The sensor structure is arranged to change a physical property in reaction to a change of the reduction of the energy density of the spread laser light in comparison to the energy density of the laser light. The sensor structure is arranged to be coupled to an electrical driver for electrically driving the laser such that the change of the physical property of the sensor structure can be detected by the electrical driver during operation of the laser device.

The sensor structure is mechanically coupled with or attached to the light spreading structure such that a potentially relevant damage or manipulation of the light spreading structure which may result in change of the reduction of the energy density of the spread laser light in comparison to the energy density of the laser light can be detected by the change of the physical property of the light spreading structure. The sensor structure may be arranged to directly or indirectly interact with the spread laser light such that a change especially a rise of the energy density of the spread laser light at essentially constant energy density of the laser light causes the change of the physical property. The change of the physical property of the light spreading structure may trigger a detectable electrical signal like a change of a voltage or current. The sensor structure may be arranged between the light spreading structure and a light outcoupling surface of the laser device such that spread laser light has to pass the sensor structure. The sensor structure is in this case essentially transparent in a wavelength range of the spread laser light (transmittance of more than 70% of the spread laser light, more preferably more than 80% of the spread laser light and most preferably more than 90% of the spread laser light).

The light spreading structure may, for example, be any kind of diffuser which is arranged between a light outcoupling surface of the laser and the light outcoupling surface of the laser device. The light spreading structure may be directly attached to the light outcoupling surface or being part of the light outcoupling surface of the laser. The light spreading structure may alternatively be integrated in a package comprising the laser.

The sensor structure may, for example, comprise a protective coating deposited on the light outcoupling surface of the light spreading structure. The protective coating may comprise a matrix material in which a sensing device is embedded. The sensing device is in this case arranged to change the physical property in reaction to the change of the reduction of the energy density of the spread laser light in comparison to the energy density of the laser light. The matrix material is essentially transparent in a wavelength range of the spread laser light. The matrix material may enable light guiding of a small part (preferably less than 1%) of the spread laser light in the protective layer. The matrix material may, for example, be characterized by a refractive index which is different than the refractive index of the material of the light spreading structure. The sensing device may, for example, be arranged to change the physical property in reaction to a change of the light guided in the protective layer.

The protective coating may alternatively or in addition comprise at least one sensing layer which is deposited on top of the light outcoupling surface of the light spreading structure. The sensing layer is in this case transparent with a transmittance as described above.

The physical property may be chosen out of the group temperature change of the sensor structure, change of electrical resistance of the sensor structure, change of capacitance of the sensor structure (or more generally electrical impedance) or change of a voltage or current generated by the sensor structure. The change of the temperature, electrical resistance or capacitance may be detectable by sensing a voltage or current change.

The sensor structure may comprise an electrically conductive material. The electrically conductive material may be arranged in a way that essentially any change of the arrangement of the conductive material results in a change of a detectable voltage if a defined current is applied to the conductive material. The sensor structure may, for example, comprise one or more conductive layers enabling a four-point-probe geometry. The four-point-probe geometry enables characterization of the full resistivity tensor. For example, it has been shown that a thin copper film will exhibit a change in local resistance of a few to a few hundred percent after mechanical damage (e.g. cracks) starts to occur in a bending test. Alternatively or in addition, two or more layers of conductive material may be separated by a nonconductive material enabling an impedance measurement especially measurement of the capacitance by applying an alternating voltage. The conductive layer or layers have to be transparent in the respective wavelength range as described above if they are arranged in the emission path of the spread laser light.

The conductive layer or layers may be embedded in a matrix material but outside the emission path of the spread laser light. The matrix material, material of the conductive layer and mechanical coupling between the matrix material and the conductive layer may in this case be arranged such that a damage of the matrix material arranged in the emission path causes with high probability a damage of the conductive layer or layers. A damage of the matrix material is with high probability coupled with a damage of the light spreading structure and corresponding of the reduction of the energy density of the spread laser light in comparison to the energy density of the laser light.

The sensor structure may alternatively or in addition be arranged to change the physical property in reaction to a change of absorption of a part of the spread laser light. Detection of the change of the physical property in reaction to a change in absorption of the spread laser light may enable the additional option to detect malfunctions of the laser or an electrical driver independent from the damage of the light spreading structure by detecting, for example, a rise of the absorbed spread laser light. The sensor structure may, for example, comprise a thermocouple structure to detect a temperature of the sensor structure in reaction to absorption of spread laser light. A rise of the absorbed spread laser light which may be caused, for example, by an unintended increase of the driving current which can be provided by an electrical driver may be detected by means of a temperature rise. A damage of the sensor structure may alternatively or in addition cause a voltage drop because the damage may reduce absorption of the spread laser light or reduce the sensitivity of the sensor structure to the absorbed spread laser light.

The sensor structure may alternatively or in addition comprise a transparent organic or inorganic semiconductor layer which is arranged to absorb a small part of the spread laser light (see transmittance described above) wherein a physical property (e.g. photo current) changes depending on the absorption of spread laser light and/or the disturbance of the absorption.

The sensor structure may comprise a mesh structure. The mesh structure is arranged such that at least a part of the spread laser light does not interact with the mesh structure during operation of the laser device. A mesh structure of conductive material, thermocouple material, absorptive material arranged in the light path of the spread laser light may enable reduced absorption. The mesh structure may alternatively or in addition enable two or more sensor points enabling local sensing of the change of the physical property (e.g. local thermocouples or semiconductor sensors). The mesh structure may be embedded in a transparent matrix material as described above.

The at least one laser may be a Vertical Cavity Surface Emitting Laser (VCSEL). The VCSEL may be arranged to emit laser light in the wavelength range between 900 and 1200 nm.

The laser device may comprise an array of lasers, preferably VCSELs, arranged on a common semiconductor substrate. The light spreading structure may comprise a material enclosing the lasers. The light spreading structure may, for example, be a diffuser integrated on wafer level (deposited on the wafer before separation of the semiconductor substrates with the arrays of lasers). The sensor structure may be deposited on top of the light spreading structure. The sensor structure may especially be deposited prior to separation of the semiconductor substrates.

The laser device may comprise the electrical driver. The electrical driver is electrically coupled to the sensor structure. The electrical driver is arranged to shut off the at least one laser during operation if the change of the physical property exceeds a predefined threshold value. The predefined threshold value may be coupled to the density of laser light emitted by the laser which may be controlled by means of a driving current applied to the laser or lasers. The predefined threshold value may therefore depend on the range of driving currents which can be provided by the electrical driver. There may be more than one predefined threshold value (e.g. upper and lower threshold value) such that, for example, damage of the sensor structure and increased absorption of spread laser light can be detected independently. The sensor structure may be integrated in an electrical driving circuit of the electrical driver. Hardware integration of the sensor structure in the electrical driving circuit may increase the level of security (e.g. integration in a feedback path of a power amplifier).

According to a further aspect a method of detecting a malfunction of a laser device is provided. The method comprising the steps of:
emitting laser light,
spreading the laser light by means of a light spreading structure such that an energy density of the spread laser light is reduced in comparison to an energy density of the laser light,
detecting a potential damage of the light spreading structure by means of a change of a physical property of a sensor structure attached to the spreading structure.

The sensor structure may therefore be mechanically coupled to the spreading structure such that essentially any physical access to the spreading structure results in mechanical interaction with the sensor structure changing at least one physical property of the sensor structure. The damage may be detected in accordance with any embodiment described above with respect to the laser device. The method may comprise the further step of switching or shutting off emission of laser light.

It shall be understood that the laser device of claim 1-14 and the method of claim 15 have similar and/or identical embodiments, in particular, as defined in the dependent claims.

It shall be understood that a preferred embodiment of the invention can also be any combination of the dependent claims with the respective independent claim.

Further advantageous embodiments are defined below.

### BRIEF DESCRIPTION OF THE DRAWINGS:

These and other aspects of the invention will be apparent from and elucidated with reference to the embodiments described hereinafter.

The invention will now be described, by way of example, based on embodiments with reference to the accompanying drawings.

In the drawings:
Fig. 1 shows a principal sketch of a cross-section of a first laser device
Fig. 2 shows a principal sketch of a top view of a second laser device
Fig. 3 shows a principal sketch of a top view of a third laser device
Fig. 4 shows a principal sketch of a cross-section of a fourth laser device
Fig. 5 shows a principal sketch of a top view of a fifth laser device
Fig. 6 shows a principal sketch of a top view of a sixth laser device
Fig. 7 shows a principal sketch of a process flow of a method of detecting a malfunction of the laser device

In the Figures, like numbers refer to like objects throughout. Objects in the Figures are not necessarily drawn to scale.

### DETAILED DESCRIPTION OF EMBODIMENTS:

Various embodiments of the invention will now be described by means of the Figures.

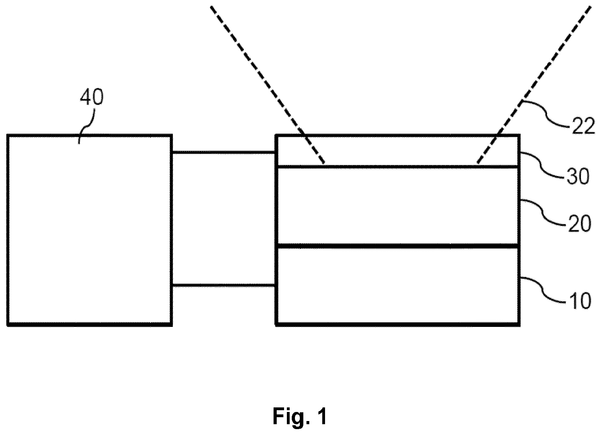

Fig. 1 shows a principal sketch of a cross-section of a first laser device. The laser device comprises a laser 10, a light spreading structure 20 deposited on top of a light outcoupling surface of the laser 10 and a sensor structure 30 deposited on top of a light outcoupling surface of the light spreading structure 20. The laser 10 is arranged to emit laser light (not shown) upon applying a driving current by means of an electrical driver 40. The electrical driver 40 is in this embodiment comprised by the laser device. The sensor structure 30 is arranged in a transmission path of spread laser light 22 emitted by the light outcoupling surface of the light spreading structure 20 which is laser light converted (reduced energy density in comparison to the laser light) by the light spreading structure 20. The sensor structure 30 is electrically coupled to the electrical driver 40 such that a change of the physical property of the sensor structure 30 which may be caused by a damage or malfunction of the light spreading structure 20 or laser 10 results in an electrical detectable signal. The electrical driver 40 is arranged to shut off the laser 10 or at least reduce the driving current supplied to the laser 10 if the electrical detectable signal exceeds or falls below a predefined threshold. The sensor structure 30 is in this embodiment a protective coating which forms part of the electronic circuitry of the electrical driver 40 such that if the output (detected electrical signal) of the protective coating is not within a given tolerance the lasing action of the laser 10 is interrupted. The tolerance of the output is set such that if the spread laser light 22 transmitted beyond the layer has most likely too high power or energy density (e.g. such that it can damage an eye) the output of the protective layer into the electrical driver 40 transfers the laser 10 in an inoperative state. The laser 10 is therefore intrinsically eye safe.

The protective coating or sensor structure 10 comprises in this embodiment a thermoelectric material that creates a voltage when it is heated e.g. using opto-thermoelectric effects. For this, a fraction of the laser light should be absorbed into the protective coating, resulting in a slight local heating where the light is being absorbed. Using a thermocouple measurement, such a measurement could be performed very locally. The thermocouple requires an interface between two materials with a different Seebeck coefficient at the location where the heating takes place, creating a thermopower voltage that is proportional to the difference in Seebeck coefficient and the reference temperature (i.e. far away from the heated spot). Depending on the Seebeck coefficient, the voltage that is thus created can range from several µV up to several hundreds of µV per heated degree (Seebeck coefficient is given in µV/K). The light spreading structure is fully covered with a homogeneous double layer made of two partially transparent thermoelectric materials, which probes the total optical output of the laser 10 (or laser array). The fraction of absorbed light induces heat, which is used to generate the thermocouple voltage. This approach would benefit from a sensitive thermocouple material with, for example, low near infrared (NIR) absorption if the laser 10 comprises one or more VCSELs, so optical power loss is low and a signal can be easily detected. Examples of such NIR transparent thermocouple materials are:
a. Indium Tin Oxide (ITO) / Antimony Tin Oxide (ATO). Seebeck coefficient: 15 µV/K.
b. Mn Doped ITO / ITO: Seebeck coefficient 94 µV/K.
c. General thermoelectric material, including BiSe2, which is 70% NIR transparent.

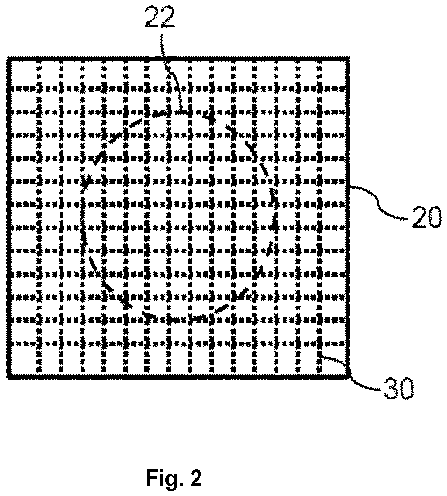

Fig. 2 shows a principal sketch of a top view of a second laser device. The sensor structure 30 is mechanically coupled to a light spreading structure 20. The spread laser light 22 is indicated by a circle. The sensor structure 30 comprises in this embodiment a patterned thin film that only partly covers the light emission surface of the light spreading structure 20 in order to minimize light losses caused by absorption. This might for example be done by patterning thin, conductive ribbons in a way that the ribbons minimally block the outgoing spread laser light 22 but still cover the light outcoupling surface of the light spreading structure 20 in a way that damage is most likely to be detected, such as using a fine mesh. Absorption may be further reduced by using materials which are essentially transparent in the wavelength range of the spread laser light 22. Example materials which may be used in case of near infrared light emission (e.g. VCSEL) are:
a. Transparent conductive oxides (TCOs), such as Indium Tin Oxide (ITO). If such TCO films are down to 100 nm thin, the transmission of NIR light increases to 70-80%, though the sheet resistance then increases. Multilayer coatings with silver or doping methods, can be used to increase sheet resistance and NIR transmittance. TCO candidates are:
   i. ITO (100 nm). Sheet resistance: varying on fabrication method ∼103 - 104 Ω/square; NIR transmittance ∼70%.
   ii. ITO / ATO wet chemical deposition. Sheet resistance: ∼102 Ω/square; NIR transmittance >90%.
   iii. Indium oxide / Silver / Indium Oxide. Sheet resistance: 10-50 Ω/square; NIR transmittance can be tuned to above 90 %.
b. Silver thin films. Sheet resistance depending on film thickness down to 10 Ω/square; NIR transmittance up to over 90%, reduced to 70% as coated on a PET/glass stack.
c. Silver grid on glass. Sheet resistance 1.5-10 kΩ/square; NIR transmittance: 85%.
d. Nanowire films, e.g.:
   i. Silver nanowires. Sheet resistance: down to 10 Ω/square; transmittance: up to 90%.
   ii. Copper nanowires. Sheet resistance: down to 10 Ω/square; NIR transmittance: over 90%.

The mesh or ribbons may be integrated in a transparent matrix material. The resistance may, for example, be measured by means of a four-point probe integrated in an electrical driver as discussed with respect to Fig. 1.

The same transparent materials may alternatively be used in a protective coating as discussed with respect to Fig. 1. Two layers of conductive transparent materials stacked upon each other with an intermediate thin nonconductive layer may be used to enable a capacitance measurement. A damage of such a double layer may at least change the capacitance but most likely even cause local short which can be easily detected.

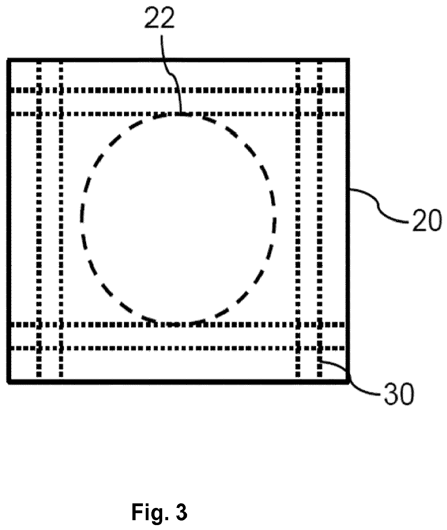

Fig. 3 shows a principal sketch of a top view of a third laser device. The sensor structure 30 comprises in this case a sensing device embedded in a matrix material, wherein the sensing device is arranged outside of the spread laser light 22 emitted by the light outcoupling surface of the light spreading structure 20. The sensing device may comprise thermocouple material as described with respect to Fig. 1 arranged in ribbons or electrically conductive material. The material can be nontransparent in the wavelength range of the spread laser light 22. The material may therefore be much more sensitive with respect to any change of the energy density of the spread laser light 22. Alternatively or in addition, the matrix material (e.g. a transparent polymer) may be arranged to guide a part of the spread laser light 22 in order to increase sensitivity of the sensor structure 30. The matrix material may be further arranged such that a serious damage of the matrix material resulting, for example, from a manipulation of the light spreading structure 20 causes a damage of the embedded sensor device with high probability.

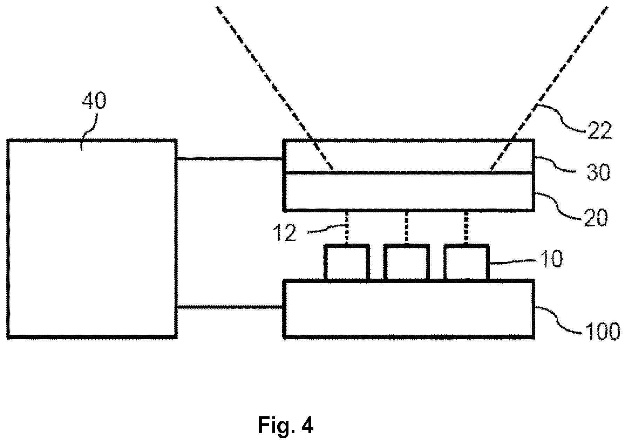

Fig. 4 shows a principal sketch of a cross-section of a fourth laser device. The laser device comprises a VCSEL array 100 comprising a multitude of lasers 10 (VCSELs). Each VCSEL emits laser light 12 which is spread by means of a light spreading structure 20 (e.g. Diffractive Optical Element) such that spread laser light 22 is emitted via a light outcoupling surface of the light spreading layer 20. A sensor structure 30 is mechanically coupled to the light outcoupling surface of the light spreading structure 20. An electrical driver 40 is coupled to the VCSEL array 100 and the sensor structure 30 in order to enable control of driving of the laser device. The VCSEL array 100, the light spreading structure 20 and the sensor structure 30 are integrated in one package (not shown). The sensor structure 30 comprises a transparent protective layer of conductive material covering the light spreading structure 20 as described above.

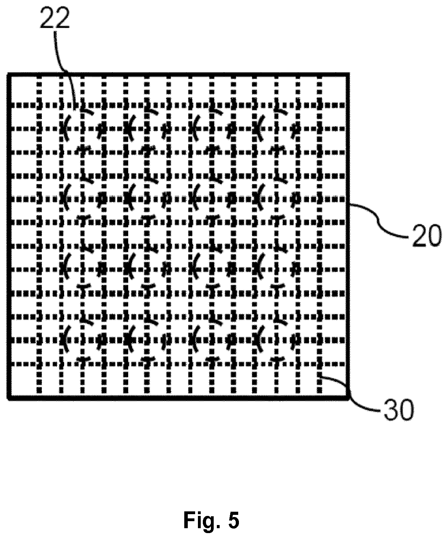

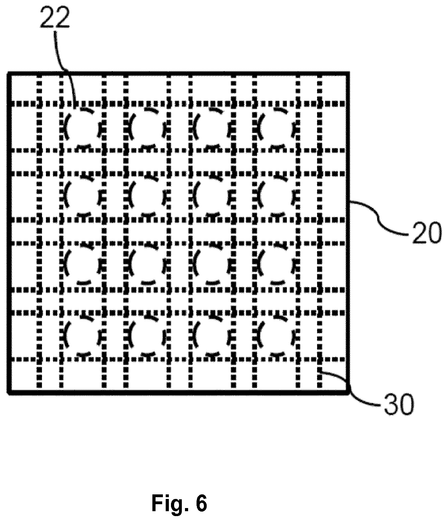

Fig. 5 shows a principal sketch of a top view of a fifth laser device which is based on the configuration discussed with respect to Fig. 4 wherein the sensor structure 30 is similar to the arrangement discussed with respect to Fig. 2. At least one crossing of a mesh of conductive material is arranged in an emission path of each VCSEL. The arrangement may enable local detection of damages of the light spreading structure 20 such that the respective VCSEL of the VCSEL array 100 may be shut off. The material used in the transmission path may be transparent or nontransparent (depending on the area covered by the respective crossing of the mesh) in the wavelength range of the spread laser light 22. Fig. 6 shows a principal sketch of a top view of a sixth laser device similar as discussed with respect to Fig. 5 in which a mesh is comprised by the sensor structure 30 such that no crossing is arranged in the emission path of the respective laser 10. The arrangement may be similar as discussed with respect to Fig. 3.

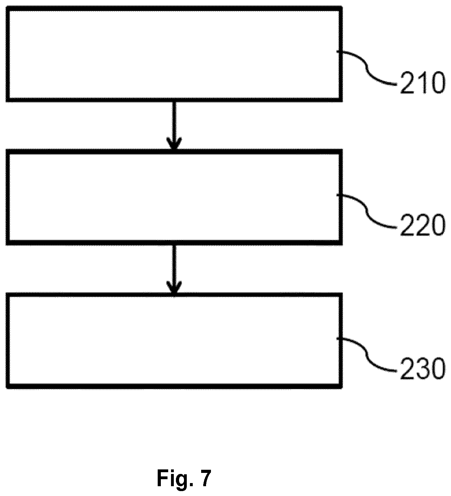

Fig. 7 shows a principal sketch of a process flow of a method of detecting a malfunction of a laser device. Laser light 12 is emitted in step 210. The laser light 12 is spread by means of a light spreading layer 220 such that an energy density of spread laser light 22 is reduced in comparison to an energy density of the laser light 12. A potential damage of the light spreading structure 20 is detected in step 230 by means of a change of a physical property of a sensor structure 30 attached to the spreading structure 20.

While the invention has been illustrated and described in detail in the drawings and the foregoing description, such illustration and description are to be considered illustrative or exemplary and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

### LIST OF REFERENCE NUMERALS:

- 10: laser
- 12: laser light
- 20: light spreading structure
- 22: spread laser light
- 30: sensor structure
- 40: electrical driver
- 100: VCSEL array
- 210: step of emitting laser light
- 220: step of spreading laser light by means of light spreading structure
- 230: step of detecting damage of light spreading structure

## Claims

1. A laser device comprising at least one laser (10) arranged to emit laser light (12), a light spreading structure (20) arranged to spread the laser light (10) such that an energy density of the spread laser light (22) is reduced in comparison to an energy density of the laser light (12), the laser device further comprising a sensor structure (30) mechanically coupled with a light outcoupling surface of the light spreading structure (20), wherein the sensor structure (30) is arranged to change a physical property in reaction to a change of the reduction of the energy density of the spread laser light (22) in comparison to the energy density of the laser light (12), and wherein the sensor structure (30) is arranged to be coupled to an electrical driver (40) for electrically driving the laser (10) such that the change of the physical property of the sensor structure (30) can be detected by the electrical driver (40) during operation of the laser device.

2. The laser device according to claim 1, wherein the sensor structure (30) comprises a protective coating deposited on the light outcoupling surface of the light spreading structure (20).

3. The laser device according to claim 1 or 2, wherein the physical property is chosen out of the group temperature change of the sensor structure (30), change of electrical impedance of the sensor structure (30), change of an electrical current generated by the sensor structure (30) or change of a voltage generated by the sensor structure (30).

4. The laser device according to anyone of the preceding claims, wherein the sensor structure (30) comprises electrically conductive material.

5. The laser device according to anyone of the preceding claims, wherein the sensor structure (30) is arranged in an optical path of the spread laser light (22).

6. The laser device according to claim 5, wherein the sensor structure (30) is arranged to change the physical property in reaction to a change of absorption of a part of the spread laser light (22).

7. The laser device according to anyone of the preceding claims, wherein the sensor structure (30) is arranged to change the physical property in reaction to a mechanical damage of the sensor structure (30).

8. The laser device according to anyone of claims 5-7, wherein the sensor structure (30) comprises a material transparent in a wavelength range of the spread laser light (22), and wherein the sensor structure (30) fully covers at least the part of the light outcoupling surface through which the spread laser light (22) can be outcoupled during operation of the laser device.

9. The laser device according to anyone of claims 1-7, wherein the sensor structure (30) comprises a mesh structure, wherein the mesh structure is arranged such that at least a part of the spread laser light (22) does not interact with the mesh structure during operation of the laser device.

10. The laser device according to anyone of the preceding claims, wherein the at least one laser (10) is a Vertical Cavity Surface Emitting Laser.

11. The laser device according to anyone of the preceding claims comprising an array of lasers (10) arranged on a common semiconductor substrate, wherein the light spreading structure (20) comprises a material enclosing the lasers (10), and wherein the sensor structure (30) is deposited on top of the light spreading structure (20).

12. The laser device according to anyone of the preceding claims further comprising the electrical driver (40), wherein the electrical driver (40) is electrically coupled to the sensor structure (30), and wherein the electrical driver (40) is arranged to shut off the at least one laser (10) during operation if the change of the physical property exceeds a predefined threshold value.

13. The laser device according to claim 12, wherein the sensor structure (30) is integrated in an electrical driving circuit of the electrical driver (40).

14. The laser device according to claim 12 or 13, wherein the predefined threshold value depends on a driving current which can be provided by the electrical driver (40).

15. A method of detecting a malfunction of a laser device, the method comprising the steps of:
emitting laser light (12),
spreading the laser light (12) by means of a light spreading structure (20) such that an energy density of the spread laser light (22) is reduced in comparison to an energy density of the laser light (12),
detecting a potential damage of the light spreading structure (20) by means of a change of a physical property of a sensor structure (30) attached to the spreading structure (20).
